# EUROPEAN PATENT APPLICATION

(11) **EP 2 088 151 A1**
(43) Date of publication of application: **12.08.2009**
(21) Application number: 07830318.7
(22) Date of filing: 23.10.2007
(51) Int. Cl.: C07F 1/12, C09K 11/06, H01L 51/50

(54) **GOLD COMPLEX, METHOD FOR PRODUCTION OF THE GOLD COMPLEX, AND ORGANIC ULTRAVIOLET ELECTROLUMINESCENT ELEMENT USING THE GOLD COMPLEX**

(30) Priority: 24.10.2006 JP 2006288385
(71) Applicant: Ube Industries, Ltd., Ube-shi Yamaguchi 755-8633 (JP)
(72) Inventor: FUJIMURA, Osamu, Ube-shi Yamaguchi 755-8633 (JP); FUKUNAGA, Kenji, Ichihara-shi Chiba 290-0045 (JP); HONMA, Takashi, Ube-shi Yamaguchi 755-8633 (JP); MACHIDA, Toshikazu, Ichihara-shi Chiba 290-0045 (JP)
(74) Representative: HOFFMANN EITLE
(86) International application number: PCT/JP2007/070584
(87) International publication number: WO 2008/050733

(57) **Abstract**

The present invention is to provide a gold complex represented by the formula (1): 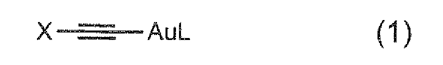 wherein L represents a nitrogen-containing heterocyclic carbene ligand, and X represents an alkyl group, cycloalkyl group, alkoxycarbonyl group, aryloxycarbonyl group, alkylaminocarbonyl group, arylaminocarbonyl group, arylalkylaminocarbonyl group, alkylmercaptocarbonyl group, arylmercaptocarbonyl group, alkylsulfonyl group or arylsulfonyl group, provided that one or a plural number of hydrogen atoms on the carbon atom(s) of X may be substituted by a halogen atom, alkyl group, cycloalkyl group, aryl group, aralkyl group, alkoxy group, aryloxy group, alkylmercapto group, arylmercapto group or substituted amino group,
a process for preparing the same, and an organic ultraviolet electroluminescent device using said gold complex.

## Description

### TECHNICAL FIELD

The present invention relates to a novel gold complex which is useful as a luminescent material, etc. for an organic ultraviolet electroluminescent device (organic ultraviolet electroluminescent device), etc. and a process for preparing the same, and an organic ultraviolet electroluminescent device using said gold complex.

### BACKGROUND ART

An ultraviolet luminescent element is expected to be used for various uses, for example, an irradiation light source for a resin-curing analysis or a marker for medical use, an excitation light source of a photocatalyst, or a constitutional part for realizing a white color LED. Heretofore, as a material for an ultraviolet luminescent device which emits light of a short wavelength region at an ultraviolet region, inorganic nitride semiconductors such as GaN (gallium nitride), InGaN (indium gallium nitride), AlGaN (aluminum gallium nitride), etc., have been used, but those using an organic material have not yet been known. By constituting a device with an organic material, flexibility can be provided and a marked reduction in manufacturing costs can be expected, but it has not yet been realized since no suitable organic ultraviolet luminescent material has yet been found out.
On the other hand, an organic EL device (organic electroluminescent device) has attracted attention as a display device for a high performance flat panel color display in recent years. As such a luminescent material, a fluorescent material which utilizes light-emission from a singlet excitation of a light-emission molecule has mainly been used, and for the purpose of accomplishing higher efficiency, lots of research and development of a phosphorescence luminescent material which utilizes light-emission from a triplet excitation have been carried out.
However, as a phosphorescence luminescent material which emits light at an ultraviolet region, for example, only one example of an iridium complex has been reported (for example, see Non-Patent Literature 1). There is disclosed a synthetic method for preparing the same only with an extremely low yield, so that it can be considered to be difficultly applied to an industrial purpose. On the other hand, with regard to a gold complex, it has been known that it emits light at a blue color region (for example, see Patent Literature 1), but it has not been reported about light emission at an ultraviolet region. A practically applicable organic ultraviolet luminescent material has a merit that it is easy in manufacturing a device as compared with an "RGB pixelization" which is a system of the conventional organic EL full color device. Also, with regard to "color conversion matrix method (CCM method)" which is superior in light emitting efficiency and color reproducibility to another system of "white color filtration method", a higher efficiency is expected to be accomplished by replacing an organic blue color luminescent material which is an excitation light source with an ultraviolet luminescent material having a higher energy, whereby it is to be a most suitable colorization method for realizing a larger-sized organic EL television in the future.
Patent Literature 1: WO 2006/080515 A1
Non-Patent Literature 1: Inorg. Chem., 44, 7992 (2005).

### DISCLOSURE OF THE INVENTION

### PROBLEMS TO BE SOLVED BY THE INVENTION

The present invention is to provide a novel gold complex (having phosphorescence emission at an ultraviolet region of 400 nm or less, and having a high melting point of 200°C or higher which can endure joule heat generating at the time of applying a voltage after preparation of a device) which is useful for a luminescent material to be used for an organic ultraviolet electric field luminescent device (organic ultraviolet electroluminescent device), etc., and a process for preparing the same, and an organic ultraviolet electroluminescent device using said gold complex.

### MEANS TO SOLVE THE PROBLEMS

The problems of the present invention can be solved by a gold complex represented by the formula (1):

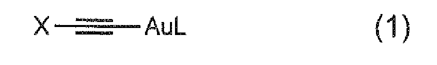

wherein L represents a nitrogen-containing heterocyclic carbene ligand, X represents an alkyl group, cycloalkyl group, alkoxycarbonyl group, aryloxycarbonyl group, alkylaminocarbonyl group, arylaminocarbonyl group, arylalkylaminocarbonyl group, alkylmercaptocarbonyl group, arylmercaptocarbonyl group, alkylsulfonyl group, or arylsulfonyl group, provided that one or a plural number of hydrogen atoms on the carbon atom(s) of X may be substituted by a halogen atom, alkyl group, cycloalkyl group, aryl group, aralkyl group, alkoxy group, aryloxy group, arylmercapto group, arylmercapto group or substituted amino group.

In the present invention, it is also provided a process for preparing the above-mentioned gold complex which comprises reacting a substituted ethynylgold-phosphine complex and a nitrogen-containing heterocyclic carbene ligand.

In the present invention, it is further provided an organic electroluminescent device which comprises an organic electroluminescent device in which a light emitting layer or a plural number of organic compound-thin layers containing a light emitting layer is/are provided between a pair of electrodes, and at least one layer of the organic compound-thin layers contains the above-mentioned gold complex.

### EFFECTS OF THE INVENTION

According to the present invention, it can be provided a novel gold complex useful as a luminescent material for an organic ultraviolet electroluminescent device, etc., and a process for preparing the same, and an organic ultraviolet electroluminescent device using said gold complex.

### BRIEF DESCRIPTION OF THE DRAWING

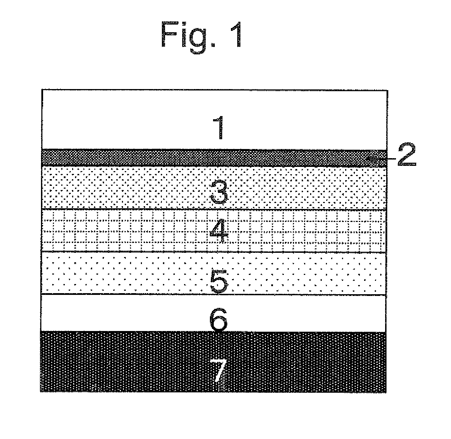

[Fig. 1] Fig. 1 is a diagrammatic view of an electroluminescent device described in Example 8, and in the figure, reference numeral 1 designates a glass substrate, 2 designates an ITO film (positive electrode), 3 designates a hole transport layer, 4 designates a light emitting layer, 5 designates a hole block layer, 6 designates an Al electrode and 7 designates an electron transport layer.

### BEST MODE TO CARRY OUT THE INVENTION

The gold complex of the present invention is shown by the above-mentioned formula (1). In the formula (1), L represents a nitrogen-containing heterocyclic carbene ligand, and X represents an alkyl group, cycloalkyl group, alkoxycarbonyl group, aryloxycarbonyl group, alkylaminocarbonyl group, arylaminocarbonyl group, arylalkylaminocarbonyl group, alkylmercaptocarbonyl group, arylmercaptocarbonyl group, alkylsulfonyl group or arylsulfonyl group.

As the above-mentioned alkyl group, an alkyl group having 1 to 10 carbon atoms is preferred, and there may be mentioned, for example, a methyl group, ethyl group, propyl group, butyl group, pentyl group, hexyl group, heptyl group, octyl group, nonyl group, decyl group, etc. Incidentally, these substituents also include its isomers such as an isopropyl group, isobutyl group, tert-butyl group, etc.

As the above-mentioned cycloalkyl group, a cycloalkyl group having 3 to 12 carbon atoms is preferred, and there may be mentioned, for example, a cyclopropyl group, cyclobutyl group, cyclopentyl group, cyclohexyl group, cycloheptyl group, cyclooctyl group, cyclononyl group, cyclodecyl group, cycloundecyl group, cyclododecyl group, etc.

As the above-mentioned alkoxycarbonyl group, an alkoxycarbonyl group having 2 to 10 carbon atoms is preferred, and there may be mentioned, for example, a methoxycarbonyl group, ethoxycarbonyl group, propoxycarbonyl group, butoxycarbonyl group, pentoxycarbonyl group, isopropoxycarbonyl group, isobutoxycarbonyl group, tert-butoxycarbonyl group, etc.

As the above-mentioned aryloxycarbonyl group, an aryloxycarbonyl group having 7 to 11 carbon atoms is preferred, and there may be mentioned, for example, a phenoxycarbonyl group, tolyloxycarbonyl group, naphthyloxycarbonyl group, etc.

As the above-mentioned alkylaminocarbonyl group, an alkylaminocarbonyl group having 2 to 10 carbon atoms is preferred, and there may be mentioned, for example, a dimethylaminocarbonyl group, diethylaminocarbonyl group, dipropylaminocarbonyl group, etc.

As the above-mentioned arylaminocarbonyl group, an arylaminocarbonyl group having 7 to 18 carbon atoms is preferred, and there may be mentioned, for example, a phenylaminocarbonyl group, diphenylaminocarbonyl group, ditolylaminocarbonyl group, naphthylaminocarbonyl group, etc.

As the above-mentioned arylalkylaminocarbonyl group, an arylalkylaminocarbonyl group having 8 to 18 carbon atoms is preferred, and there may be mentioned, for example, a phenylmethylaminocarbonyl group, phenylethylaminocarbonyl group, tolylmethylaminocarbonyl group, tolylethylaminocarbonyl group, naphthylmethylaminocarbonyl group, naphthylethylaminocarbonyl group, etc.

As the above-mentioned alkylmercaptocarbonyl group, an alkylmercaptocarbonyl group having 2 to 18 carbon atoms is preferred, and there may be mentioned, for example, a methylmercaptocarbonyl group, ethylmercaptocarbonyl group, propylmercaptocarbonyl group, etc.

As the above-mentioned arylmercaptocarbonyl group, an arylmercaptocarbonyl group having 7 to 18 carbon atoms is preferred, and there may be mentioned, for example, a phenylmercaptocarbonyl group, tolylmercaptocarbonyl group, naphthylmercaptocarbonyl group, etc.

As the above-mentioned alkylsulfonyl group, an alkylsulfonyl group having 1 to 12 carbon atoms is preferred, and there may be mentioned, for example, a methylsulfonyl group, ethylsulfonyl group, propylsulfonyl group, etc.

As the above-mentioned arylsulfonyl group, an arylsulfonyl group having 6 to 18 carbon atoms is preferred, and there may be mentioned, for example, a phenylsulfonyl group, tolylsulfonyl group, naphthylsulfonyl group, etc.

One or a plural number of hydrogen atoms on the carbon atom(s) of X may be substituted by a halogen atom, alkyl group, cycloalkyl group, alkenyl group, aryl group, aralkyl group, alkoxy group, aryloxy group, arylmercapto group, arylmercapto group or substituted amino group.

As the above-mentioned halogen atom, there may be mentioned a fluorine atom, chlorine atom, bromine atom and iodine atom.

As the above-mentioned alkyl group, an alkyl group having 1 to 20 carbon atoms, particularly 1 to 12 carbon atoms is preferred, and there may be mentioned, for example, a methyl group, ethyl group, propyl group, butyl group, pentyl group, hexyl group, heptyl group, octyl group, nonyl group, decyl group, undecyl group, dodecyl group, etc. These substituents also include their isomers.

As the above-mentioned cycloalkyl group, a cycloalkyl group having 3 to 7 carbon atoms is particularly preferred, and there may be mentioned, for example, a cyclopropyl group, cyclobutyl group, cyclopentyl group, cyclohexyl group, cycloheptyl group, etc.

As the above-mentioned alkenyl group, an alkenyl group having 2 to 20 carbon atoms, particularly 2 to 12 carbon atoms is preferred, and there may be mentioned, for example, a vinyl group, propenyl group, butenyl group, pentenyl group, hexenyl group, heptenyl group, octenyl group, nonenyl group, decenyl group, undecenyl group, dodecenyl group, etc. These substituents also include their isomers.

As the above-mentioned aryl group, an aryl group having 6 to 20 carbon atoms, particularly 6 to 16 carbon atoms is preferred, and there may be mentioned, for example, a phenyl group, tolyl group, xylyl group, naphthyl group, dimethylnaphthyl group, anthryl group, phenanthryl group, fluorenyl group, pyrenyl group, etc. These substituents also include their isomers.

As the above-mentioned aralkyl group, an aralkyl group having 7 to 20 carbon atoms is preferred, and there may be mentioned, for example, a benzyl group, naphthylmethyl group, indenylmethyl group, biphenylmethyl group, etc.

As the above-mentioned alkoxy group, an alkoxy group having 1 to 10 carbon atoms is particularly preferred, and there may be mentioned, for example, a methoxy group, ethoxy group, propoxy group, butoxy group, pentanoxy group, hexanoxy group, heptanoxy group, octanoxy group, nonanoxy group, decanoxy group, etc. These substituents also include their isomers.

As the above-mentioned aryloxy group, an aryloxy group having 6 to 14 carbon atoms is particularly preferred, and there may be mentioned, for example, a phenoxy group, tolyloxy group, xylyloxy group, naphthoxy group, etc. These substituents also include their isomers.

As the above-mentioned alkylmercapto group, an alkylmercapto group having 1 to 6 carbon atoms is preferred, and there may be mentioned, for example, a methylmercapto group, ethylmercapto group, propylmercapto group, butylmercapto group, pentylmercapto group and hexylmercapto group. These substituents also include their isomers.

As the above-mentioned arylmercapto group, an arylmercapto group having 6 to 14 carbon atoms is preferred, and there may be mentioned, for example, a phenylmercapto group, tolylmercapto group, xylylmercapto group, naphthylmercapto group, etc. These substituents also include their isomers.

As the above-mentioned substituted amino group, a substituted amino group having 1 to 14 carbon atoms is preferred and there may be mentioned, for example, a methylamino group, ethylamino group, propylamino group, butylamino group, dimethylamino group, diethylamino group, dipropylamino group, phenylamino group, tolylamino group, xylylamino group, naphthylamino group, phenylmethylamino group, phenylethylamino group, diphenylamino group, ditolylamino group, dixylylamino group, etc. These substituents also include their isomers.

When a hydrogen atom on the carbon atom of X is substituted by an alkyl group, alkenyl group, aryl group, aralkyl group, alkoxy group, aryloxy group or substituted amino group, adjacent groups may be bonded together to form a ring.

As a ring which is formed by the above-mentioned adjacent groups to be bonded, there may be mentioned, for example, a cyclopentene ring, cyclohexene ring, cycloheptene ring, benzene ring, naphthalene ring, tetrahydrofuran ring, benzopyrane ring, N-methylpyrrolidine ring, N-methylpiperidine ring, etc.

In the present invention, at least one gold complex selected from the following (1) to (10) is preferred.
(1) A gold complex in which X is selected from an alkyl group having 1 to 10 carbon atoms and a cycloalkyl group having 3 to 12 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(2) A gold complex in which X is selected from an alkoxycarbonyl group having 2 to 10 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(3) A gold complex in which X is selected from an aryloxylcarbonyl group having 7 to 11 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(4) A gold complex in which X is selected from an alkylaminocarbonyl group having 2 to 10 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(5) A gold complex in which X is selected from an arylaminocarbonyl group having 7 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(6) A gold complex in which X is selected from an arylalkylaminocarbonyl group having 8 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(7) A gold complex in which X is selected from an alkylmercaptocarbonyl group having 2 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(8) A gold complex in which X is selected from an arylmercaptocarbonyl group having 7 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(9) A gold complex in which X is selected from an alkylsulfonyl group having 1 to 12 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

(10) A gold complex in which X is selected from an arylsulfonyl group having 6 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

Also, the nitrogen-containing heterocyclic carbene ligand is represented by the formula (2) or (3):

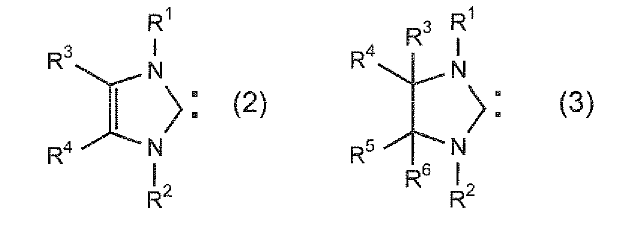

wherein R¹ and R² may be the same or different from each other, and each represent an alkyl group, cycloalkyl group, polycycloalkyl group or aryl group, R³, R⁴, R⁵ and R⁶ may be the same or different from each other, and each represent a hydrogen atom, halogen atom, alkyl group, alkenyl group, aryl group, aralkyl group, alkoxy group, aryloxy group, nitro group, cyano group or dialkylamino group, and adjacent groups may be bonded together to form a ring; provided that an optional hydrogen atom(s) of R¹ to R⁶ may be substituted by a halogen atom, alkyl group, cycloalkyl group, alkenyl group, aryl group, aralkyl group, alkoxy group or aryloxy group.

Here, R¹ and R² each represent an alkyl group, cycloalkyl group, polycycloalkyl group or aryl group, and the alkyl group, cycloalkyl group and aryl group have the same meanings as those defined in the alkyl group, cycloalkyl group and aryl group which is/are to substitute one or a plural number of hydrogen atom(s) on the carbon atom(s) of the above-mentioned X.

As the above-mentioned polycycloalkyl group, a polycycloalkyl group having 6 to 10 carbon atoms is preferred, and there may be mentioned a bicyclo-[2.1.1]-hexyl group, bicyclo-[2.2.1]-heptyl group, bicyclo-[2.2.2]-octyl group, bicyclo-[3.3.0]-octyl group, bicyclo-[4.3.0]-nonyl group, bicyclo-[4.4.0]-octyl group, adamantyl group, etc.

Also, R³, R⁴, R⁵ and R⁶ each represent a hydrogen atom, halogen atom, alkyl group, alkenyl group, aryl group, aralkyl group, alkoxy group, aryloxy group, nitro group, cyano group or dialkylamino group, and the alkyl group, alkenyl group, aryl group, aralkyl group, alkoxy group, aryloxy group or dialkylamino group have the same meanings as those defined in the substituent(s) which is/are to substitute one or a plural number of hydrogen atom(s) on the carbon atom(s) of the above-mentioned X.

In the present invention, it is preferred that R¹ and R² each represent an alkyl group having 1 to 20 carbon atoms, cycloalkyl group having 3 to 7 carbon atoms, polycycloalkyl group having 6 to 10 carbon atoms or aryl group having 6 to 20 carbon atoms, and R³, R⁴, R⁵ and R⁶ each represent a hydrogen atom, halogen atom, alkyl group having 1 to 20 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, nitro group, cyano group or dialkylamino group having 2 to 10 carbon atoms.

An optional hydrogen atom(s) of R¹, R², R³, R⁴, R⁵ and R⁶ may be substituted by a halogen atom, alkyl group, cycloalkyl group, alkenyl group, aryl group, aralkyl group, alkoxy group or aryloxy group, and these groups have the same meanings as those defined in the substituent(s) which is/are to substitute one or a plural number of hydrogen atom(s) on the carbon atom(s) of the above-mentioned X. Of these, as R¹ and R², a tert-butyl group, 2,6-diisopropylphenyl group, 2,4,6-trimethylphenyl group or adamantyl group is preferred, and as R³, R⁴, R⁵ and R⁶, a hydrogen atom or halogen atom, particularly a chlorine atom is preferred.

Specific examples of the nitrogen-containing heterocyclic carbene ligand (L) in the present invention may be mentioned a ligand, for example, represented by the formula (4) to (13):

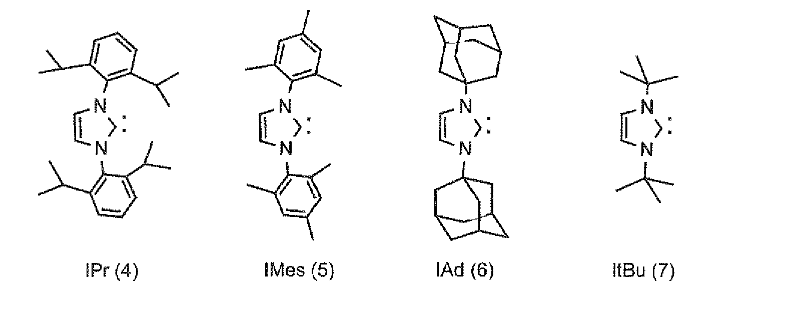

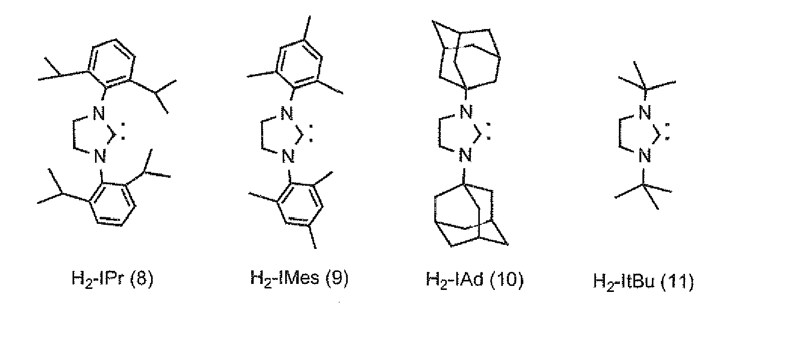

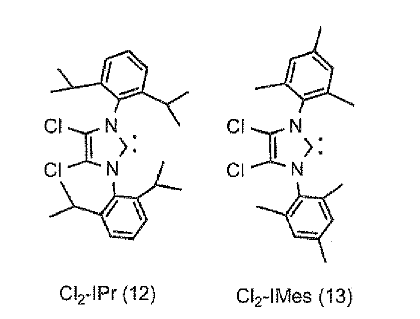

and the like.

The gold complex represented by the formula (1) of the present invention can be obtained, for example, by a reaction scheme (1):

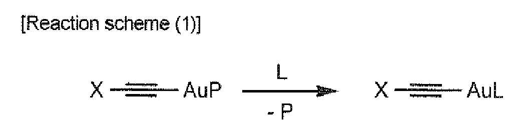

wherein X and L have the same meanings as defined above, and P represents a monodentate phosphine ligand,
in which a substituted ethynylgold-phosphine complex and a nitrogen-containing heterocyclic carbene ligand (L) are reacted (This reaction proceeds with yield of substantially 80% or higher).

As the above-mentioned monodentate phosphine ligand (P), there may be mentioned, for example, bis(pentafluorophenyl)phenylphosphine, (4-bromophenyl)-diphenylphosphine, diallylphenylphosphine, dicyclohexylphenylphosphine, diethylphenylphosphine, 4-(dimethylamino)phenyldiphenylphosphine, dimethylphenylphosphine, diphenyl(2-methoxyphenyl)phosphine, diphenyl(pentafluorophenyl)-phosphine, diphenylpropylphosphine, diphenyl-2-pyridylphosphine, diphenyl(p-tolyl)phosphine, diphenylvinylphosphine, ethyldiphenylphosphine, isopropyldiphenylphosphine, methyldiphenylphosphine, tribenzylphosphine, tributylphosphine, tri-tert-butylphosphine, tricyclohexylphosphine, tricyclopentylphosphine, triethylphosphine, tri-2-furylphosphine, triisobutylphosphine, triisopropylphosphine, tripropylphosphine, trimethylphosphine, trioctylphosphine, triphenylphosphine, tris(4-chlorophenyl)-phosphine, tris(3-chlorophenyl)phosphine, tris(2,6-dimethoxyphenyl)phosphine, tris(4-fluorophenyl)phosphine, tris(3-fluorophenylphosphine), tris(4-methoxyphenyl)-phosphine, tris(3-methoxyphenyl)phosphine, tris(2-methoxyphenyl)phosphine, tris(4-trifluoromethylphenyl)phosphine, tris(pentafluorophenyl)phosphine, tris(2,4,6-trimethoxyphenyl)phosphine, tris(2,4,6-trimethylphenyl)phosphine, tri-m-tolylphosphine, tri-o-tolylphosphine, tri-p-tolylphosphine, benzyldiphenylphosphine, bis(2-methoxyphenyl)phenylphosphine, diphenylcyclohexylphosphine, 2-(di-tert-butylphosphino)-biphenyl, 2-(dicyclohexylphosphino)biphenyl, neomenthyldiphenylphosphine, p-tolyldiphenylphosphine, triallylphosphine, 2,4,4-trimethylpentylphosphine, tri(1-naphthyl)phosphine, tris(hydroxymethyl)phosphine, tris(hydroxypropyl)phosphine, etc. These materials can be used a commercially available product as such.

The above-mentioned substituted ethynylgold-phosphine complex can be obtained by, for example, a reaction scheme (2):

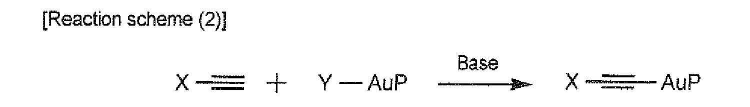

wherein X and P have the same meanings as defined above, and Y represents a halogen atom,
in which a gold-halogenophosphine complex and a substituted phenylethyne are reacted (for example, see Journal of Chemical Society, Dalton Trans., 1986, 411.). This reaction proceeds with yield of about 90% or higher. Accordingly, in the reaction of the present invention, the reaction proceeds with high yield of about 70% or higher with the two steps to provide a desired gold complex.

The above-mentioned gold-halogenophosphine complex can be synthesized by a method conventionally known in the art (for example, see Lecture on Experimental Chemistry, 4th edition, published by MARUZEN Co., Ltd., p. 455, vol. 18 (1991)).

As the above-mentioned nitrogen-containing heterocyclic carbene ligand, a commercially available product may be used as such, or, for example, that synthesized according to the conventionally known method may be used (for example, see J. Am. Chem. Soc., 114, 5530 (1992) and WO 98/27064 A).

As the above-mentioned substituted ethyne compound represented by the formula (14):

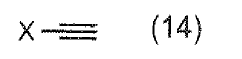

wherein X has the same meaning as defined above, a commercially available product may be used, or it may be synthesized by the conventionally known substituted ethyne synthesis method (for example, see Comprehensive Organic Transformation VCH Publishers, Inc. p.283, (1989)).

In synthesis of the gold complex of the present invention, an amount of the nitrogen-containing heterocyclic carbene ligand to be used is preferably 1 to 3 mol, more preferably 1 to 1.5 mol based on 1 mol of the substituted ethynylgold-plosphine complex.

The solvent to be used for the synthesis of the gold complex according to the present invention is not specifically limited so long as it does not interfere the reaction, and there may be used, for example, an ether such as tetrahydrofuran, furan, dioxane, tetrahydropyrane, diethyl ether, diisopropyl ether, dibutyl ether, etc., an aliphatic hydrocarbon such as pentane, hexane, heptane, octane, etc.; an aromatic hydrocarbon such as benzene, toluene, xylene, etc.; a halogenated aliphatic hydrocarbon such as dichloromethane, dichloroethane, dichloropropane, etc.; a halogenated aromatic hydrocarbon such as chlorobenzene, etc. These solvents may be used singly or in combination of two or more kinds in admixture.

An amount of the above-mentioned solvent to be used may be optionally adjusted depending on a degree of uniformity or condition of stirring of the reaction mixture, and it is preferably 1 to 30L, more preferably 5 to 20L based on 1 mol of the substituted ethynylgold-phosphine complex.

Synthesis of the gold complex of the present invention can be carried out, for example, by a method in which the substituted ethynylgold-phosphine complex, the nitrogen-containing heterocyclic carbene ligand (which is formed by a reaction of a nitrogen-containing heterocyclic hydrohalide and a base) and a solvent are mixed, and reacted while stirring, etc. A reaction temperature at that time is preferably 0 to 120°C, more preferably 20 to 100°C, and a reaction pressure is not specifically limited.

The gold complex of the present invention can be isolated and formed after completion of the reaction by the conventionally known method, for example, neutralization, extraction, filtration, concentration, distillation, recrystallization, sublimation, chromatography, etc.

As the gold complex of the present invention, there may be mentioned, for example, compounds represented by the formulae (15) to (21):

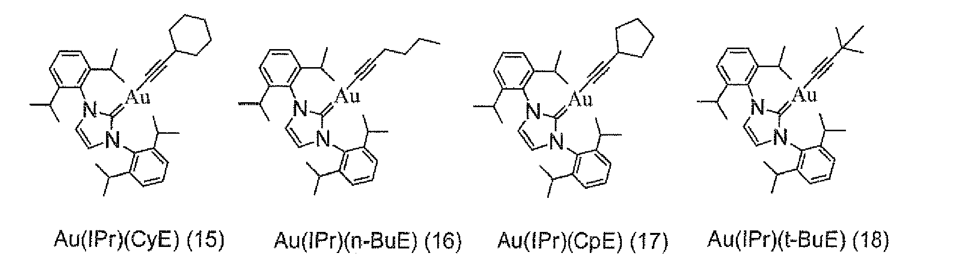

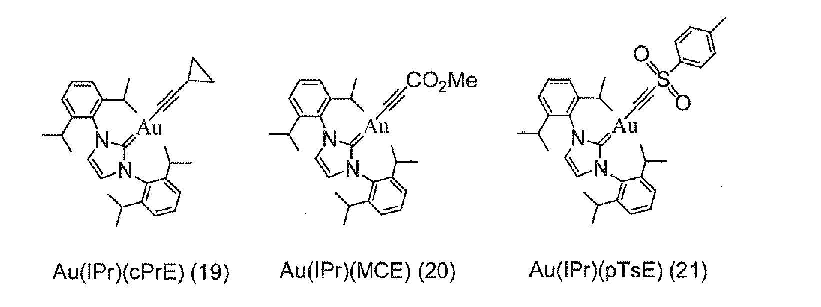

and the like.

The gold complex of the present invention showed phosphorescence emission in an ultraviolet region with an emission maximum wavelength of 360 to 380 nm and CIE color coordinates of (0.162, 0.060) to (0.176, 0.116) in chloroform at a temperature of 77K (Kelvin) under ultraviolet ray irradiation. According to this fact, it is suggested that said gold complex can be suitable used as a luminescent material for an organic ultraviolet luminescent device and an electroluminescent device.

Also, as a result of thermal analysis, a melting point of the gold complex of the present invention is 200°C or higher, so that it is suggested that it can be suitably used as an organic electroluminescent device.

Next, with regard to the organic ultraviolet electroluminescent device (hereinafter referred to as ultraviolet EL device) of the present invention, its embodiments are shown.

The ultraviolet EL device of the present invention contains said gold complex in at least one layer of the organic compound-thin layers, and the ultraviolet EL device is an ultraviolet EL device preferably having a single layer or a plural number of layers of the organic compound layer(s) between a pair of electrodes. The organic compound layer means a light emitting layer, an electron injection layer or a hole transport layer.

The ultraviolet EL device of a single layer type has a light emitting layer between an anode and a cathode. The light emitting layer contains a luminescent material, and may further contain a hole injection material or an electron injection material for transporting holes injected from the anode or electrons injected from the cathode to the luminescent material.

Examples of the organic ultraviolet EL device of a multilayer type may include, for example, those having a multilayer stacked structure such as (anode/hole injection layer/light emitting layer/cathode), (anode/light emitting layer/electron injection layer/cathode) or (anode/hole injection layer/light emitting layer/electron injection layer/cathode), etc.

The light emitting layer may contain, in addition to the gold complex represented by the formula (I), for example, at least one material selected from the group consisting of conventionally known organic light emitting device materials (for example, phthalocyanine derivatives, naphthalocyanine derivatives, porphyrin derivatives, oxazole, oxadiazole, triazole, imidazole, imidazolone, imidazolethione, pyrazoline, pyrazolone, tetrahydroimidazole, oxazole, oxadiazole, hydrazone, acylhydrazone, polyarylalkane, stilbene, butadiene, benzidine type triphenylamine, styrylamine type triphenylamine, diamine type triphenylamine, etc., and a derivative thereof, and polyvinylcarbazole, polysilane, polystyrene, polyvinylnaphthalene, conductive polymer, fluorenone, anthraquinodimethane, diphenoquinone, thiopyran dioxide, oxazole, oxadiazole, triazole, imidazole, perylenetetracarboxylic acid, fluorenylidenemethane, anthraquinodimethane, anthrone, etc., and a derivative thereof, etc., condensed polycyclic aromatic (for example, anthracene, naphthalene, phenanthrene, pyrene, tetracene, pentacene, coronene, chrysene, fluorescein, perylene, rubrene or a derivative thereof, etc.), aromatic silicon compound (for example, tetraphenylsilane and its derivatives, etc.), aromatic germanium compound (tetraphenyl germanium, etc.).

An amount of said gold complex to be added to the organic compound layer is 0.005 to 1 g, more preferably 0.01 g to 0.20 g based on 1 g of the organic compound layer.

In the ultraviolet EL device, the luminescent material(s), other doping material(s), hole injection material(s) and electron injection material(s) can be used in combination. Further, each of the hole injection layer, light emitting layer and electron injection layer may be comprised of two or more layers. In this case, with respect to the hole injection layer, a layer which injects holes from the electrode is called hole injection layer, and a layer which receives holes from the hole injection layer and transports the holes to the light emitting layer is called hole transport layer. Similarly, with respect to the electron injection layer, a layer which injects electrons from the electrode is called electron injection layer, and a layer which receives electrons from the electron injection layer and transports the electrons to the light emitting layer is called electron transport layer. These layers are appropriately selected and used depending on factors, such as an energy level or heat resistance of the material or adhesion to the organic compound layer or metal electrode.

An effective hole injection material among the conventionally known hole injection materials which can be used in the organic ultraviolet EL device of the present invention is an aromatic tertiary amine derivative or a phthalocyanine derivative, and specifically, there may be mentioned, for example, an aromatic tertiary amine derivative such as triphenylamine, tritolylamine, tolyldiphenylamine, N,N'-diphenyl-N,N'-(3-methylphenyl)-1,1'-biphenyl-4,4'-diamine (hereinafter referred to as TPD), N,N,N',N'-(4-methylphenyl)-1,1'-phenyl-4,4'-diamine, N,N,N',N'-(4-methylphenyl)-1,1'-biphenyl-4,4'-diamine, N,N-diphenyl-N,N'-di-α-naphthyl-1,1'-biphenyl-4,4'-diamine (hereinafter referred to as α-NPD), N,N'-(methylphenyl)-N,N'-(4-n-butylphenyl)-phenanthrene-9,10-diamine, N,N-bis(4-di-4-tolylaminophenyl)-4-phenyl-cyclohexane, etc., or an oligomer or polymer having these aromatic tertiary amine skeletons, etc.; and a phthalocyanine derivative and naphthalocyanine derivative such as H₂Pc, CuPc, CoPc, NiPc, ZnPc, PdPc, FePc, MnPc, ClAlPc, ClGaPc, ClInPc, ClSnPc, Cl₂SiPc, (HO)AlPc, (HO)GaPc, VOPc, TiOPc, MoOPc, GaPc-C)-GaPc, etc., but the hole injection material is not limited to these.

In the organic ultraviolet EL device of the present invention, as a conventionally known electron injection material which is effective, there may be mentioned a metal complex compound or a nitrogen-containing 5-membered ring derivative (preferably oxazole, thiazole, oxadiazole, thiadiazole or triazole derivatives), and there may be mentioned, for example, a metal complex compound such as 8-hydroxyquinolinate lithium, bis(8-hydroxyquinolinato)zinc, bis(8-hydroxyquinolinato)copper, bis(8-hydroxyquinolinato)manganese, tris(8-hydroxyquinolinato)aluminum (hereinafter referred to as Alq₃.), tris(2-methyl-8-hydroxyquinolinato)aluminum, tris(8-hydroxy-quinolinato)gallium, bis(10-hydroxybenzo[h]quinolinato)beryllium, bis(10-hydroxy-benzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, etc.; a nitrogen-containing 5-membered derivative such as 2,5-bis(1-phenyl)-1,3,4-oxazole, dimethyl POPOP (here, POPOP represents 1,4-bis(5-phenyloxazol-2-yl)benzene.), 2,5-bis(1-phenyl)-1,3,4-thiazole, 2,5-bis(1-phenyl)-1,3,4-oxadiazole, 2-(4'-tert-butylphenyl)-5-(4"-biphenyl)-1,3,4-oxadiazole, 2,5-bis(1-naphthyl)-1,3,4-oxadiazole, 1,4-bis[2-(5-phenyloxa-diazolyl)]benzene, 1,4-bis[2-(5-phenyloxadiazolyl)-4-tert-butylbenzene], 2-(4'-tert-butylphenyl)-5-(4"-biphenyl)-1,3,4-thiadiazole, 2,5-bis(1-naphthyl)-1,3,4-thiadiazole, 1,4-bis[2-(5-phenylthiadiazolyl)]benzene, 2-(4'-tert-butylphenyl)-5-(4"-biphenyl)-1,3,4-triazole, 2,5-bis(1-naphthyl)-1,3,4-triazole, 1,4-bis[2-(5-phenyltriazolyl)]benzene, etc., but the electron injection material is not limited to these.

In the organic ultraviolet EL device of the present invention, an inorganic compound layer may be provided between the light emitting layer and the electrode for the purpose of improving a charge injection property.

As the inorganic compound layer, there may be used an alkali metal fluoride such as LiF, etc.; an alkaline earth metal fluoride such as BaF₂, SrF₂, etc.; an alkali metal oxide such as Li₂O, etc.; an alkaline earth metal oxide such as RaO, SrO, etc.

As the conductive material to be used for the anode of the organic ultraviolet EL device according to the present invention, there may be mentioned those having a work function of larger than around 4 eV, for example, carbon atom, aluminum, vanadium, iron, cobalt, nickel, tungsten, silver, gold, platinum, palladium and an alloy thereof, a metal oxide to be used for an ITO (a substance in which 5 to 10% of tin oxide is added to indium oxide) substrate or a NESAa substrate such as tin oxide, indium oxide, etc., and further an organic conductive resin such as polythiophene or polypyrrole, etc. It is, however, desired to use a material wherein a work function of a conductive material to be used for an anode is not less than 0.1 eV larger than a work function of a conductive material to be used for a cathode of said device.

As the conductive material to be used for the cathode, there may be used those having a work function of smaller than around 4eV, for example, magnesium, calcium, tin, lead, titanium, yttrium, lithium, ruthenium, manganese, aluminum, etc., or an alloy thereof. Here, as the alloy, there may be mentioned magnesium/silver, magnesium/- indium, lithium/aluminum, etc. A ratio of the alloy is controlled by the temperature of a deposition source, atmosphere, vacuum degree, etc., and is not particularly limited.
It is, however, desired to use a material wherein a work function of a conductive material to be used for a cathode is not less than 0.1 eV smaller than a work function of a conductive material to be used for an anode of said device.

The anode and the cathode may be constituted by a layer constitution of two layers or more, if necessary.

In the organic ultraviolet EL device of the present invention, at least one surface thereof is desirably transparent in the light emission wavelength region of the device. Also, the substrate is desirably transparent.

The transparent electrode can be obtained by using the above-mentioned conductive material, and setting conditions so that a predetermined light-transmittance is ensured by a method such as deposition or sputtering, etc.

An electrode at the light-emitting surface is desirably set a light transmission rate of 10% or higher.

The substrate is not particularly limited so long as it has mechanical and thermal strengths, and has transparency, and a glass substrate or a transparent resin film is used.

As the transparent resin film, there may be mentioned, for example, polyethylene, ethylene-vinyl acetate copolymer, ethylene-vinyl alcohol copolymer, polypropylene, polystyrene, polymethyl methacrylate, polyvinyl chloride, polyvinyl alcohol, polyvinylbutyral, Nylon, polyether etherketone, polysulfone, polyether sulfone, tetrafluoroethylene-perfluoroalkylvinyl ether copolymer, polyvinyl fluoride, tetrafluoroethylene-ethylene copolymer, tetrafluoroethylene-hexafluoropropylene copolymer, polychlorotrifluoroethylene, polyvinylidene fluoride, polyester, polycarbonate, polyurethane, polyimide, polyetherimide, polyimide, polypropylene, etc.

To the organic ultraviolet EL device of the present invention may be provided a protective layer on the surface of the device to improve stability against temperature, humidity, atmosphere, etc., or whole devices may be protected by silicone oil, resin, etc.

Also, for formation of each layer of the organic ultraviolet EL device, either of a dry film-forming method such as vacuum deposition, sputtering, plasma, ion plating, etc., or a wet film-forming method such as spin coating, dipping, flow coating, etc., can be applied. A film thickness is not particularly limited, and preferably 5 nm to 10 µm, more preferably 10 nm to 0.2 µm.

In the case of the wet film-forming method, said gold complex is dissolved or dispersed in a solvent such as ethanol, chloroform, tetrahydrofuran, dioxane, etc., and formed on each layer to prepare a thin film.

As the dry film-forming method, vacuum deposition is preferred, and a thin film can be prepared by using a vacuum deposition device at a vacuum degree of 2x10⁻³ Pa or lower and making a substrate temperature room temperature, a gold complex of the present invention placed in a deposition cell is heated and said material is evaporated. At this time, a thermocouple contacted to a deposition cell or a noncontact infrared thermometer, etc., is suitably used to control a temperature of the deposition source. Also, a deposition thickness meter is suitably used to control a deposited amount.

As the deposition thickness meter, suitably used are those in which a quartz crystal oscillator provided at the opposed position to a deposition source is used, a weight of a deposited film attached to the surface of the above-mentioned quartz crystal oscillator is measured by the change in an oscillation frequency of said oscillator, and a film thickness is obtained from the measured weight with a real time.

Co-deposition of a host material such as CBP, etc., and the gold complex of the present invention can be carried out by using respective deposition sources and controlling temperatures thereof independently.

Here, to either of the organic thin film layers may be added, for example, a resin including a photoconductive resin such as a polystyrene, polycarbonate, polyacrylate, polyester, polyamide, polyurethane, polysulfone, polymethyl methacrylate, polymethyl acrylate, cellulose, etc., and a copolymer thereof; a photoconductive resin such as a poly-N-vinylcarbazole, polysilane, etc., a conductive resin such as polythiophene, polypyrrole, etc., and an additive such as an antioxidant, an ultraviolet ray absorber, a plasticizer, etc., for the purpose of improving film-forming property, preventing from causing pin holes of the film, etc.

The organic ultraviolet EL device of the present invention can be expected to be used as an irradiation light source of a resin curing analysis or a marker for medical use, an excitation light source of a photocatalyst, or a constitutional part for realizing a white color LED, and further as an excitation light source for a full color organic EL device which is expected to be used for a display device for a high performance flat panel color display.

### EXAMPLES

Next, the present invention is explained more concretely by referring to Examples, but the scope of the present invention is not limited by these.

### Example 1 (Synthesis of cyclohexylethynyl[1,3-bis(2,6-diisopropylphenyl)imidazol-2-ylidene]gold [Au(IPr)(CyE)])

In 25 ml of Schlenk tube were charged 1,3-bis(2,6-diisaprapylphenyl)-imidazolium chloride (IPrH⁺Cr; 0.187 g, 0.44 mmol), potassium tert-butoxide (85% by weight product, 0.075 g, 0.57 mmol) and tetrahydrofuran (7 ml) under argon atmosphere, and after stirring the mixture at room temperature for 15 minutes, tetrahydrofuran was distilled off under reduced pressure. Toluene (7 ml) was added to the mixture, and the mixture was stirred at 70°C for 5 minutes. The resulting mixture was filtered, and the filtrate was added dropwise to 30 ml of separate Schlenk tube into which cyclohexylethynyl(triphenylphosphine)gold (0.195 g, 0.34 mmol) and 7 ml of toluene had been charged. After dropwise addition, the mixture was heated at 70°C for 2.5 hours. The reaction mixture was cooled to room temperature, then, toluene was added to the mixture, and the extract was washed with water and made pH 7. After drying the mixture over anhydrous sodium sulfate, the solvent was distilled off by an evaporator under reduced pressure. The obtained solid was dissolved in ethyl acetate and reprecipitated by hexane to obtain 0.20 g of the objective material as white solid. (Yield: 85%)

¹H-NMR (300 MHz, CDCl₃) δ: 7.49-7.44 (m, 2H), 7.28-7.25 (m, 4H), 7.06 (d, 2H), 2.65-2.60 (sept, 4H), 2.32-2.25 (m, 1H), 1.79-1.10 (m, 34H)
EI-MS (M/Z): 692 (M)⁺
Luminescence analysis (CHCl₃, 77K, Ex 240 nm) λ (nm): 374 (max)
Thermal analysis: Melting point: 214°C

| Elemental analysis | |
|---|---|
| Observed value | C: 61.21, H: 6.95, N: 3.98 |
| Theoretical value | C: 60.68, H: 6.84, N: 4.04 |

### Example 2 (Synthesis of n-butylethynyl[1,3-bis(2,6-diisopropylphenyl)imidazol-2-ylidene]gold [Au(IPr)(n-BuE)])

In 25 ml of Schlenk tube were charged 1,3-bis(2,6-diisopropylphenyl)-imidazolium chloride (IPrH⁺Cl⁻; 0.187 g, 0.52 mmol), potassium tert-butoxide (85% by weight product, 0.089 g, 0.68 mmol) and tetrahydrofuran (8 ml) under argon atmosphere, and after stirring the mixture at room temperature for 15 minutes, tetrahydrofuran was distilled off under reduced pressure. Toluene (8 ml) was added to the mixture, and the mixture was stirred at 70°C for 5 minutes. The resulting mixture was filtered, and the filtrate was added dropwise to 30 ml of separate Schlenk tube to which n-butylethyrzyl(triphenylphosphine)gold (0.215 g, 0.40 mmol) and 8 ml of toluene had been charged. After dropwise addition, the mixture was heated at 70°C for 2.5 hours. The reaction mixture was cooled to room temperature, then, toluene was added to the mixture, and the mixture was washed with water and made pH 7. After drying the mixture over anhydrous sodium sulfate, the solvent was distilled off by an evaporator under reduced pressure. The obtained solid was washed with hexane to obtain 0.22 g of the objective material as white solid. (Yield: 82%)

¹H-NMR (300 MHz, CDCl₃) δ: 7.49-7.44 (m, 2H), 7.28-7.25 (m, 4H), 7.07 (d, 2H), 2.66-2.52 (sept, 4H), 2.21-2.16 (m, 2H), 1.45-1.13 (m, 28H), 0.82-0.77 (m, 3H)
EI-MS (M/Z): 666 (M)⁺
Luminescence analysis (CHCl₃, 77K, Ex 240 nm) λ (nm): 374 (max)
Thermal analysis: Melting point: 215°C

| Elemental analysis | |
|---|---|
| Observed value | C: 59.18, H: 6.59, N: 3.21 |
| Theoretical value | C: 59.45, H: 6.80, N: 4.20 |

### Example 3 (Synthesis of cyclopentylethynyl[1,3-bis(2,6-diisopropylphenyl)imidazol-2-ylidene]gold [Au(IPr)(CpE)])

In 25 ml of Schlenk tube were charged 1,3-bis(2,6-diisopropylphenyl)-imidazolium chloride (IPrH⁺Cl⁻; 0.251 g, 0.59 mmol), potassium tert-butoxide (85% by weight product, 0.100 g, 0.76 mmol) and tetrahydrofuran (9 ml) under argon atmosphere, and after stirring the mixture at room temperature for 15 minutes, tetrahydro furan was distilled off under reduced pressure. Toluene (9 ml) was added to the mixture, and the mixture was stirred at 70°C for 5 minutes. The resulting mixture was filtered, and the filtrate was added dropwise to 30 ml of separate Schlenk tube to which cyclopentylethynyl(triphenylphosphine)gold (0.250 g, 0.45 mmol) and 9 ml of toluene had been charged. After dropwise addition, the mixture was heated at 70°C for 2.5 hours. The reaction mixture was cooled to room temperature, then, toluene was added to the mixture, and the mixture was washed with water and made pH 7. After drying the mixture over anhydrous sodium sulfate, the solvent was distilled off by an evaporator under reduced pressure. The obtained solid was dissolved in ethyl acetate and reprecipitated from hexane to obtain 0.25 g of the objective material as white solid. (Yield: 82%)

¹H-NMR (300 MHz, CDCl₃) δ: 7.50-7.45 (m, 2H), 7.28-7.26 (m, 4H), 7.06 (d, 2H), 2.65-2.60 (m, 5H), 1.84-1.81 (m, 2H), 1.60-1.16 (m, 28H), 0.90-0.86 (m, 2H)
EI-MS (M/Z): 678 (M)⁺
Luminescence analysis (CHCl₃, 77K, Ex 240 nm) λ (nm): 374 (max)
Thermal analysis: Melting point: 244°C

| Elemental analysis | |
|---|---|
| Observed value | C: 60.22, H: 6.47, N: 4.19 |
| Theoretical value | C: 60.17, H: 6.68, N: 4.13 |

### Example 4 (Synthesis of tert-butylethynyl[1,3-bis(2,6-diisopropylphenyl)imidazol-2-ylidene]gold [Au(IPr)(t-BuE)])

In 25 ml of Schlenk tube were charged 1,3-bis(2,6-diisopropylphenyl)-imidazolium chloride (IPrH⁺Cl⁻; 0.238 g, 0.56 mmol), potassium tert-butoxide (85% by weight product, 0.096 g, 0.73 mmol) and tetrahydrofuran (8.5 ml) under argon atmosphere, and after stirring the mixture at room temperature for 15 minutes, tetrahydrofuran was distilled off under reduced pressure. Toluene (8.5 ml) was added to the mixture, and the mixture was stirred at 70°C for 5 minutes. The resulting mixture was filtered, and the filtrate was added dropwise to 30 ml of separate Schlenk tube to which tertbutylethynyl(triphenylphosphine)gold (0.235 g, 0.43 mmol) and 8.5 ml of toluene had been charged. After dropwise addition, the mixture was heated at 70°C for 2.5 hours. The reaction mixture was cooled to room temperature, then, toluene was added to the mixture, and the mixture was washed with water and made pH 7. After drying the mixture over anhydrous sodium sulfate, the solvent was distilled off by an evaporator under reduced pressure. The obtained solid was washed with hexane to obtain 0.25 g of the objective material as white solid. (Yield: 86%)

¹H-NMR (300 MHz, CDCl₃) δ: 7.50-7.45 (m, 2H), 7.29-7.25 (m, 4H), 7.06 (d, 2H), 2.67-2.55 (sept, 4H), 1.34 (d, 12H), 1.18 (d, 12H), 1.11 (s, 9H)
EI-MS (M/Z): 666 (M)⁺
Luminescence analysis (CHCl₃, 77K, Ex 240 nm) λ (nm): 374 (max)
Thermal analysis: Melting point: 201°C

| Elemental analysis | |
|---|---|
| Observed value | C: 59.16, H: 6.72, N: 4.18 |
| Theoretical value | C: 59.45, H: 6.80, N: 4.20 |

### Example 5 (Synthesis of cyclopropylethynyl[1,3-bis(2,6-diisopropylphenyl)imidazol-2-ylidene]gold [Au(IPr)(cPrE)])

In 25 ml of Schlenk tube were charged 1,3-bis(2,6-diisopropylphenyl)-imidazolium chloride (IPrH⁺Cl⁻; 0.238 g, 0.56 mmol), potassium tert-butoxide (85% by weight product, 0.075 g, 0.57 mmol) and tetrahydrofuran (9 ml) under argon atmosphere, and after stirring the mixture at room temperature for 15 minutes, tetrahydrofuran was distilled off under reduced pressure. Toluene (9 ml) was added to the mixture, and the mixture was stirred at 70°C for 5 minutes. The resulting mixture was filtered, and the filtrate was added dropwise to 30 ml of separate Schlenk tube to which cyclopropylethynyl(triphenylphosphine)gold (0.225 g, 0.43 mmol) and 9 ml of toluene had been charged. After dropwise addition, the mixture was heated at 70°C for 2.5 hours. The reaction mixture was cooled to room temperature, then, toluene was added to the reaction mixture, and the mixture was washed with water and made pH 7. After drying the mixture over anhydrous sodium sulfate, the solvent was distilled off by an evaporator under reduced pressure. The obtained crude reaction product was purified by column chromatography (Hexane/AcOEt=5/1) using silica gel, and washed with hexane and filtered to obtain 0.13 g of the objective material as white solid. (Yield: 42%)

¹H-NMR (300 MHz, CDCl₃) δ: 7.49-7.44 (m, 2H), 7.27-7.25 (m, 4H), 7.06 (d, 2H), 2.65-2.51 (sept, 4H), 1.34 (d, 12H), 1.20-1.18 (m, 13H), 0.54-0.51 (m, 4H)
EI-MS (M/Z): 650 (M)⁺
Luminescence analysis (CHCl₃, 77K, Ex 240 nm) λ (nm): 374 (max)
Thermal analysis Melting point: 265°C

| Elemental analysis | |
|---|---|
| Observed value | C: 58.79, H: 6.12, N: 4.35 |
| Theoretical value | C: 59.07, H: 6.35, N: 4.31 |

### Example 6 (Synthesis of methoxycarbonylethynyl[1,3-bis(2,6-diisopropylphenyl)-imidazol-2-ylidene]gold [Au(IPr)(MCE)])

In 25 ml of Schlenk tube were charged 1,3-bis(2,6-diisopropylphenyl)-imidazolium chloride (IPrH⁺Cl⁻; 0.191 g, 0.45 mmol), potassium tert-butoxide (85% by weight product, 0.077 g, 0.59 mmol) and tetrahydrofuran (7 ml) under argon atmosphere, and after stirring the mixture at room temperature for 15 minutes, tetrahydrofuran was distilled off under reduced pressure. Toluene (7 ml) was added to the mixture, and the mixture was stirred at 70°C for 5 minutes. The resulting mixture was filtered, and the filtrate was added dropwise to 30 ml of separate Schlenk tube to which methoxycarbonylethynyl(triphenylphosphine)gold (0.188 g, 0.35 mmol) and 7 ml of toluene had been charged. After dropwise addition, the mixture was heated at 70°C for 2.5 hours. The reaction mixture was cooled to room temperature, then, toluene was added to the mixture, and the mixture was washed with water and made pH 7. After drying the mixture over anhydrous sodium sulfate, the solvent was distilled off by an evaporator under reduced pressure. The obtained crude reaction product was purified by column chromatography (Hexane/AcOEt=5/1) using silica gel, and washed and filtered with hexane to obtain 0.16 g of the objective material as white solid. (Yield: 70%)

¹H-NMR (300 MHz, CDCl₃) δ: 7.61-7.47 (m, 2H), 7.29-7.26 (m, 4H), 7.13 (d, 2H), 3.59 (s, 3H), 2.57-2.45 (sept, 4H), 1.42 (d, 12H), 1.20 (d, 12H)
EI-MS (M/Z): 668 (M)⁺
Luminescence analysis (CHCl₃, 77K, Ex 240 nm) λ (nm): 374 (max)
Thermal analysis: Melting point: 303°C

| Elemental analysis | |
|---|---|
| Observed value | C: 55.02, H: 5.63, N: 4.14 |
| Theoretical value | C: 55.69, H: 5.88, N: 4.19 |

### Example 7 (Synthesis of p-tolylsulfonylethynyl[1,3-bis(2,6-diisopropylphenyl)-imidazol-2-ylidene]gold [Au(IPr)(pTsE)])

In 15 ml of Schlenk tube were charged 1,3-bis(2,6-diisopropylphenyl)-imidazolium chloride (IPrH⁺Cl⁻; 0.128 g, 0.30 mmol), potassium tert-butoxide (85% by weight product, 0.050 g, 0.38 mmol) and tetrahydrofuran (4.6 ml) under argon atmosphere, and after stirring the mixture at room temperature for 15 minutes, tetrahydrofuran was distilled off under reduced pressure. Toluene (4.6 ml) was added to the mixture, and the mixture was stirred at 70°C for 5 minutes. The resulting mixture was filtered, and the filtrate was added dropwise to 25 ml of separate Schlenk tube to which p-tolylsulfonylethynyl(triphenylphosphine)gold (0.145 g, 0.23 mmol) and 4.6 ml of toluene had been charged. After dropwise addition, the mixture was heated at 70°C for 2.5 hours. The reaction mixture was cooled to room temperature, then, toluene was added to the mixture, and the mixture was washed with water and made pH 7. After drying the mixture over anhydrous sodium sulfate, the solvent was distilled off by an evaporator under reduced pressure. The obtained crude reaction product was purified by column chromatography (Hexane/AcOEt=5/1 to 3/1) using silica gel, and washed and filtered with hexane to obtain 0.13 g of the objective material as white solid. (Yield: 74%)

¹H-NMR (300 MHz, CDCl₃) δ: 7.80-7.76 (m, 2H), 7.54-7.48 (m, 2H), 7.30-7.19 (m, 6H), 7.13 (d, 2H), 2.54-2.42 (sept, 4H), 2.37 (s, 3H), 1.30-1.28 (m, 12H), 1.21-1.19 (m,
12H)
EI-MS (M/Z): 764 (M)⁺
Luminescence analysis (CHCl₃, 77K, Ex 240 nm) λ (nm): 364 (max)
Thermal analysis: Melting point: 268°C

| Elemental analysis | |
|---|---|
| Observed value | C: 56.55, H: 5.56, N: 3.59 |
| Theoretical value | C: 56.54, H: 5.67, N: 3.66 |

### Example 8 Preparation of organic electroluminescent device containing [Au(IPr)(CyE)] in organic light emitting layer as a guest

By using a glass with indium tin oxide (hereinafter abbreviated to as ITO) coated film manufactured by EHC as a substrate for a transparent electrode, a hole transport layer 3 (film thickness: 27 nm) comprising Baytron PAI4083 (hereinafter abbreviated to as Baytron) manufactured by TA Chemical Co., Ltd. was formed on the above-mentioned substrate by spin casting.
Spin casting was carried out by using a spin coater ACT-300D manufactured by Active Co., with a rotation rate of 1000 rpm, and the cast film was dried in a vacuum oven maintained at 100 to 120°C with the substrate for one hour.
Then, a light emitting layer 4 (Film thickness: 47 nm) containing 5.6% by weight of [Au(IPr)(CyE)] in a poly-2-vinylnaphthalene (available from Polymer Source Co., Mn: 195000, Mw/Mn 1.5) was prepared on the hole transport layer 3 by spin casting from a chloroform solution with a solid content of 0.4% by weight.
Subsequently, by using a vacuum deposition device VPC-260F manufactured by ULVAC KIKO Inc., and at a vacuum degree of 2x10⁻³ Pa or less, a hole block layer 5 comprising 3-(4-biphenylyl)-4-phenyl-5-tertiary-butylphenyl-1,2,4-triazole (hereinafter abbreviated to as TAZ) with a thickness of 30 nm, an electron transport layer 6 comprising lithium fluoride (hereinafter abbreviated to as LiF) of 0.5 nm, and aluminum (Al) as an electrode 7 of 100 nm were successively vacuum deposited on the light emitting layer 4 to prepare an electroluminescent device. Vacuum deposition was carried out by charging a starting material in a crucible placed opposing to the substrate, and heating the starting material with the crucible.
When an interelectrode voltage was raised by performing energization making the ITO electrode 2 of the above-mentioned device as a positive electrode and making the Al electrode 7 as a negative electrode, the device started blue light luminescence of the degree which can be clearly recognized by the naked eye from near +12 V and light luminescence was carried out in 1.52 cd/m² at +34 V. Efficiency of a current relating to the light luminescence of this device was determined by the following formula.

Current efficiency=(Light luminescence brightness per unit area)/(Current density per unit area)

The current efficiency thus determined was 0.015 cd/A at +36V.

### Reference example 1 (Synthesis of (cyclohexylethynyl)(triphenylphosphine)gold [Au(PPh₃)(CyE)])

In 30 ml of Schlenk tube were charged Au(PPh₃)Cl (0.247 g, 0.50 mmol), cyclohexylacetylene (97 µL, 0.75 mmol) and ethanol (10 ml) under argon atmosphere, then, sodium ethoxide (208 µl, 0.53 mmol: an ethanol solution with a concentration: 2.55 mol/L (liter)) was added dropwise to the mixture, and the mixture was stirred at room temperature for 17 hours. The white precipitate obtained by the reaction was filtered, and washed successively with ethanol (12 mlx3 times), water (12 mlx3 times) and ethanol (6 mlx3 times), and vacuum dried to obtain 0.25 g of the objective compound as white powder. (Yield: 90%)

¹H-NMR (300 MHz, CDCl₃) δ: 7.57-7.26 (m, 15H), 2.52-2.48 (m, 1H), 1.97-1.93 (m, 2H), 1.77-1.72 (m, 2H), 1.54-1.43 (m, 2H), 1.30-1.22 (m, 4H)
FAB-MS (M/Z): 567 (M+H)⁺

### Reference example 2 (Synthesis of (n-butylethynyl)(triphenylphosphine)gold [Au(PPh₃)(n-BuE)])

In 30 ml of Schlenk tube were charged Au(PPh₃)Cl (0.247 g, 0.50 mmol), 1-hexyne (85 µL, 0.75 mmol) and ethanol (10 ml) under argon atmosphere, then, sodium ethoxide (208 µl, 0.53 mmol: an ethanol solution with a concentration: 2.55 mol/L (liter)) was added dropwise to the mixture, and the mixture was stirred at room temperature for 17 hours. After the reaction, ethanol was distilled off under reduced pressure, the obtained residue was dissolved in methylene chloride and then washed with water. After drying the mixture over anhydrous sodium sulfate, the solvent was distilled off by an evaporator under reduced pressure. The obtained solid was washed with hexane to obtain 0.25 g of the objective material as pale yellowish solid. (Yield: 94%)

¹H-NMR (300 MHz, CDCl₃) δ: 7.56-7.39 (m, 15H), 2.41-2.36 (m, 2H), 1.60-1.42 (m, 4H), 0.93-0.89 (m, 3H)
FAB-MS (M/Z): 541 (M+H)⁺

### Reference example 3 (Synthesis of (cyclopentylethynyl)(triphenylphosphine)gold [Au(PPh₃)(CpE)])

In 30 ml of Schlenk tube were charged Au(PPh₃)Cl (0.247 g, 0.50 mmol), cyclopentylacetylene (85% by weight product, 97 µL, 0.75 mmol) and ethanol (10 ml) under argon atmosphere, then, sodium ethoxide (208 µl, 0.53 mmol: an ethanol solution with a concentration: 2.55 mol/L (liter)) was added dropwise to the mixture, and the mixture was stirred at room temperature for 17 hours. After the reaction, ethanol was distilled off under reduced pressure, the obtained residue was dissolved in methylene chloride and then washed with water. After drying the mixture over anhydrous sodium sulfate, the solvent was distilled off by an evaporator under reduced pressure. The obtained solid was washed with hexane to obtain 0.27 g of the objective material as white solid. (Yield: 96%)

¹H-NMR (300 MHz, CDCl₃) δ: 7.56-7.39 (m, 15H), 2.71-2.81 (m, 1H), 2.02-1.99 (m, 2H), 1.75-1.51 (m, 6H)
FAB-MS (M/Z): 553 (M+H)⁺

### Reference example 4 (Synthesis of (tert-butylethynyl)(triphenylphosphine)gold [Au(PPh₃)(t-BuE)])

In 25 ml Schlenk tube were charged Au(PPh₃)Cl (0.247 g, 0.50 mmol), 3,3-dimethyl-1-butyne (93 µL, 0.75 mmol) and ethanol (10 ml) under argon atmosphere, then, sodium ethoxide (208 µl, 0.53 mmol: an ethanol solution with a concentration: 2.55 mol/L (liter)) was added dropwise to the mixture, and the mixture was stirred at room temperature for 17 hours. After the reaction, ethanol was distilled off under reduced pressure, the obtained residue was dissolved in methylene chloride and then washed with water. After drying the mixture over anhydrous sodium sulfate, the solvent was distilled off by an evaporator under reduced pressure. The obtained solid was washed with hexane to obtain 0.25 g of the objective material as white solid. (Yield: 93%)

¹H-NMR (300 MHz, CDCl₃) δ: 7.57-7.26 (m, 15H), 1.31 (s, 9H)
FAB-MS (M/Z): 541 (M+H)⁺

### Reference example 5 (Synthesis of (cyclopropylethynyl)(triphenylphosphine)gold [Au(PPh₃)(cPrE)])

In 30 ml of Schlenk tube were charged Au(PPh₃)Cl (0.247 g, 0.50 mmol), cyclopropylacetylene (87 µL, 0.75 mmol) and ethanol (10 ml) under argon atmosphere, then, sodium ethoxide (208 µl, 0.53 mmol: an ethanol solution with a concentration: 2.55 mol/L (liter)) was added dropwise to the mixture, and the mixture was stirred at room temperature for 17 hours. After the reaction, ethanol was distilled off under reduced pressure, the obtained residue was dissolved in methylene chloride and then washed with water. After drying the mixture over anhydrous sodium sulfate, the solvent was distilled off by an evaporator under reduced pressure. The obtained solid was washed with hexane to obtain 0.24 g of the objective material as white solid. (Yield: 91 %)

¹H-NMR (300 MHz, CDCl₃) δ: 7.56-7.39 (m, 15H), 1.39-1.32 (m, 1H), 0.75-0.72 (m,
4H)
FAB-MS (M/Z): 525 (M+H)⁺

### Reference example 6 (Synthesis of (methoxycarbonylethynyl)(triphenylphosphine)gold [Au(PPh₃)(MCE)])

In 30 ml of Schlenk tube were charged Au(PPh₃)Cl (0.247 g, 0.50 mmol), methylpropiolate (67 µL, 0.75 mmol) and methanol (10 ml) under argon atmosphere, then, sodium methoxide (76 µl, 0.53 mmol: a methanol solution with a concentration: 6.95 mol/L (liter)) was added dropwise to the mixture, and the mixture was stirred at room temperature for 17 hours. The white precipitate obtained by the reaction was filtered, and washed successively with methanol (12 mlx3 times), water (12 mlx3 times) and methanol (6 mlx3 times), and vacuum dried to obtain 0.20 g of the objective compound as white powder. (Yield: 74%)

¹H-NMR (300 MHz, CDCl₃) δ: 7.56-7.42 (m, 15H), 3.73 (s, 3H)
FAB-MS (M/Z): 543 (M+H)⁺

### Reference example 7 (Synthesis of (p-tolylsulfonylethynyl)(triphenylphosphine)gold [Au(PPh₃)(pTsE)])

In 30 ml of Schlenk tube were charged Au(PPh₃)Cl (0.247 g, 0.50 mmol), p-tolylsulfonylethyne (0.135 g, 0.75 mmol) and ethanol (10 ml) under argon atmosphere, then, sodium ethoxide (208 µl, 0.53 mmol: an ethanol solution with a concentration: 2.55 mol/L (liter)) was added dropwise to the mixture, and the mixture was stirred at room temperature for 17 hours. The white precipitate obtained by the reaction was filtered, and washed successively with ethanol (12 mlx3 times), water (12 mlx3 times) and ethanol (6 mlx3 times), and vacuum dried to obtain 0.16 g of the objective compound as white powder. (Yield: 49%)

¹H-NMR (300 MHz, CDCl₃) δ: 7.96-7.92 (m, 2H), 7.56-7.31 (m, 15H), 7.29-7.26 (m, 2H), 2.42 (s, 3H) FAB-MS (M/Z): 639 (M+H)⁺

### UTILIZABILITY IN INDUSTRY

The present invention is to provide a novel gold complex useful as a luminescent material for an organic ultraviolet electric field luminescent device (organic ultraviolet electroluminescent device), etc., and a process for preparing the same, and an organic ultraviolet electroluminescent device using said gold complex.

## Claims

1. A gold complex represented by the formula (1): 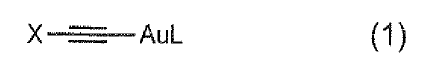 wherein L represents a nitrogen-containing heterocyclic carbene ligand, and X represents an alkyl group, a cycloalkyl group, an alkoxycarbonyl group, an aryloxylcarbonyl group, an alkylaminocarbonyl group, an arylaminocarbonyl group, an arylalkylaminocarbonyl group, an alkylmercaptocarbonyl group, an arylmercaptocarbonyl group, an alkylsulfonyl group or an arylsulfonyl group; provided that one or a plural number of hydrogen atoms on the carbon atom(s) of X may be substituted by a halogen atom, an alkyl group, a cycloalkyl group, an aryl group, an aralkyl group, an alkoxy group, an aryloxy group, an alkylmercapto group, an arylmercapto group or a substituted amino group.

2. The gold complex according to Claim 1, wherein L is represented by the formula (2) or (3): 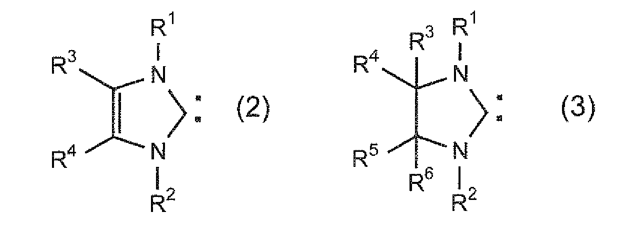 wherein R¹ and R² may be the same or different from each other, and each represent an alkyl group, cycloalkyl group, polycycloalkyl group or aryl group, R³, R⁴, R⁵ and R⁶ may be the same or different from each other, and each represent a hydrogen atom, halogen atom, alkyl group, alkenyl group, aryl group, aralkyl group, alkoxy group, aryloxy group, nitro group, cyano group or dialkylamino group, and adjacent groups may be bonded together to form a ring; and an optional hydrogen atom of R¹ to R⁶ may be substituted by a halogen atom, alkyl group, cycloalkyl group, alkenyl group, aryl group, aralkyl group, alkoxy group or aryloxy group.

3. The gold complex according to Claim 2, wherein R¹ and R² each represent an alkyl group having 1 to 20 carbon atoms, a cycloalkyl group having 3 to 7 carbon atoms, a polycycloalkyl group having 6 to 10 carbon atoms or an aryl group having 6 to 20 carbon atoms, R³, R⁴, R⁵ and R⁶ each represent a hydrogen atom, halogen atom, alkyl group having 1 to 20 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, nitro group, cyano group or dialkylamino group having 2 to 10 carbon atoms.

4. The gold complex according to Claim 3, wherein the polycycloalkyl group is a bicyclo-[2.1.1]-hexyl group, bicyclo-[2.2.1]-heptyl group, bicyclo-[2.2.2]-octyl group, bicyclo-[3.3.0]-octyl group, bicyclo-[4.3.0]-nonyl group, bicyclo-[4.4.0]-octyl group or adamantyl group.

5. The gold complex according to Claim 2 or 3, wherein R¹ and R² is a tert-butyl group, 2,6-diisopropylphenyl group, 2,4,6-trimethylphenyl group or adamantyl group, R³, R⁴, R⁵ and R⁶ each is a hydrogen atom or chlorine atom.

6. The gold complex according to Claim 1, wherein X is selected from an alkyl group having 1 to 10 carbon atoms and cycloalkyl group having 3 to 12 carbon atoms, one or a plural number of hydrogen atoms on the carbon atom(s) of X may be substituted by a fluorine atom, chlorine atom, bromine atom, iodine atom, alkyl group having I to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

7. The gold complex according to Claim 1, wherein X is selected from an alkoxycarbonyl group having 2 to 10 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

8. The gold complex according to Claim 1, wherein X is selected from an aryloxycarbonyl group having 7 to 11 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

9. The gold complex according to Claim 1, wherein X is selected from an alkylaminocarbonyl group having 2 to 10 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

10. The gold complex according to Claim 1, wherein X is selected from an arylaminocarbonyl group having 7 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

11. The gold complex according to Claim 1, wherein X is selected from an arylalkylaminocarbonyl group having 8 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

12. The gold complex according to Claim 1, wherein X is selected from an alkylmercaptocarbonyl group having 2 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

13. The gold complex according to Claim 1, wherein X is selected from an arylmercaptocarbonyl group having 7 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

14. The gold complex according to Claim 1, wherein X is selected from an alkylsulfonyl group having 1 to 12 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

15. The gold complex according to Claim 1, wherein X is selected from an arylsulfonyl group having 6 to 18 carbon atoms, and one or a plural number of hydrogen atoms on the carbon atom(s) of X may be substituted by a fluorine atom, chlorine atom, bromine atom, iodine atom, alkyl group having 1 to 20 carbon atoms, cycloalkyl group having 3 to 7 carbon atoms, alkenyl group having 2 to 20 carbon atoms, aryl group having 6 to 20 carbon atoms, aralkyl group having 7 to 20 carbon atoms, alkoxy group having 1 to 10 carbon atoms, aryloxy group having 6 to 14 carbon atoms, alkylmercapto group having 1 to 6 carbon atoms, arylmercapto group having 6 to 14 carbon atoms or substituted amino group having 1 to 14 carbon atoms.

16. The gold complex according to Claim 1 or 6, wherein X is a methyl group, ethyl group, propyl group, butyl group, pentyl group, isopropyl group, isobutyl group, tert-butyl group, cyclopentyl group or cyclohexyl group.

17. The gold complex according to Claim 1 or 7, wherein X is a methoxycarbonyl group, ethoxycarbonyl group, propoxycarbonyl group, butoxycarbonyl group, pentoxycarbonyl group, isopropoxycarbonyl group, isobutoxycarbonyl group or tert-butoxycarbonyl group.

18. The gold complex according to Claim 1 or 8, wherein X is a phenoxycarbonyl group, tolyloxycarbonyl group or naphthyloxycarbonyl group.

19. The gold complex according to Claim 1 or 9, wherein X is a dimethylaminocarbonyl group, diethylaminocarbonyl group or dipropylaminocarbonyl group.

20. The gold complex according to Claim 1 or 10, wherein X is a phenylaminocarbonyl group, diphenylaminocarbonyl group, ditolylaminocarbonyl group or naphthylaminocarbonyl group.

21. The gold complex according to Claim 1 or 11, wherein X is a phenylmethylaminocarbonyl group, phenylethylaminocarbonyl group, tolylmethylaminocarbonyl group, tolylethylaminocarbonyl group, naphthylmethylaminocarbonyl group or naphthylethylaminocarbonyl group.

22. The gold complex according to Claim 1 or 12, wherein X is a methylmercaptocarbonyl group, ethylmercaptocarbonyl group or propylmercaptocarbonyl group.

23. The gold complex according to Claim 1 or 13, wherein X is a phenylmercaptocarbonyl group, tolylmercaptocarbonyl group or naphthylmereaptocarbonyl group.

24. The gold complex according to Claim 1 or 14, wherein X is a methylsulfonyl group, ethylsulfonyl group or propylsulfonyl group.

25. The gold complex according to Claim 1 or 15, wherein X is a phenylsulfonyl group, tolylsulfonyl group or naphthylsulfonyl group.

26. The gold complex according to any one of Claims 1 to 25, wherein the gold complex according to Claim 1 is a gold complex having a phosphorescence emission peak at an ultraviolet region of 400 nm or less.

27. A process for preparing the gold complex according to Claim 1, which comprises reacting a substituted ethynylgold-phosphine complex and a nitrogen-containing heterocyclic carbene ligand.

28. The process for preparing the gold complex according to Claim 27, wherein the nitrogen-containing heterocyclic carbene ligand is obtained by a reaction of a nitrogen heterocyclic hydrohalide and a base.

29. The process for preparing the gold complex according to Claim 27, wherein the reaction is carried out by using 1 to 3 mol of the nitrogen-containing heterocyclic carbene ligand based on 1 mol of the substituted ethynylgold-phosphine complex.

30. The process for preparing the gold complex according to any one of Claims 27 to 29, wherein the reaction is carried out by mixing the substituted ethynylgold-phosphine complex and the nitrogen-containing heterocyclic carbene ligand, and stirring the mixture in the presence of a solvent at a temperature of 0 to 120°C.

31. An organic electroluminescent device which comprises an organic electroluminescent device in which a light emitting layer or a plural number of organic compound-thin layers containing a light emitting layer is/are formed between a pair of electrodes, and at least one layer of the organic compound-thin layer contains the gold complex according to Claim 1.
